Europäisches Patentamt

European Patent Office

Office européen des brevets

(11) Veröffentlichungsnummer: **0 262 440**
**A2**

## (12) EUROPÄISCHE PATENTANMELDUNG

(21) Anmeldenummer: 87112828.6

(22) Anmeldetag: 02.09.87

(51) Int. Cl.⁴: **G02B 6/10 , H01S 3/19**

(30) Priorität: 29.09.86 DE 3633079

(43) Veröffentlichungstag der Anmeldung:
06.04.88 Patentblatt 88/14

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Heinen, Jochen, Dr.**
**Dianastrasse 38**
**D-8013 Haar(DE)**

(54) Verfahren zur Erzeugung eines Streifenwellenleiters in einer epitaktischen Hetero-Schichtstruktur.

(57) Verfahren zur Erzeugung eines Streifenlasers mit BH-Schichtstruktur, wobei aus der Schichtstruktur ein erhabener Streifen (1) herausgeätzt und dieser Streifen (1) mittels einer Abtragschmelze seitlich angelöst wird. Bei bekannten derartigen Verfahren werden die seitlichen Begrenzungsflächen (21, 22) des Streifens (1) einer Atmosphäre und/oder Chemikalien ausgesetzt. Dadurch haben diese Flächen eine verminderte Qualität, die Ursache für Alterungsmechanismen sind, die ein solcher Streifenlaser zeigt. Zur Erzielung seitlicher Begrenzungsflächen hoher Perfektion wird so vorgegangen, daß die seitlichen Begrenzungsflächen (21, 22) der laseraktiven Schicht (2) des Streifenlasers von einem von der Abtragschmelze gelösten Teil (5) dieser Schicht (2) abgedeckt belassen werden, und daß dieser Teil (5) mit als Wachstumsschmelze zur Erzeugung einer seitlich an die laseraktive Schicht (2) angrenzenden Epitaxieschicht (6) verwendet wird.

FIG 2b

## Verfahren zur Erzeugung eines Streifenwellenleiters in einer epitaktischen Hetero-Schichtstruktur

Die vorliegende Erfindung betrifft ein Verfahren zur Erzeugung eines Streifenwellenleiters nach dem Oberbegriff des Patentanspruchs 1.

Ein Beispiel eines Verfahrens der genannten Art ist ein Verfahren zur Herstellung eines Halbleiterlasers in Form eines Streifenlasers mit BH-Schichtstruktur (BH steht für "Burried Hetero"), bei dem die laseraktive Zone eine vergrabene Zone ist. Das Verfahren wird üblicherweise so durchgeführt, daß in eine Epitaxiescheibe mit Doppelhetero-Schichtstruktur ein erhabener Streifen entsprechend der Breite des Streifenlasers geätzt wird. In einem zweiten Epitaxieprozeß werden die seitlichen Begrenzungsflächen des Streifens - oft mit Vielfachschichten zur besseren Stromblockade - mit InP zugewachsen. Zur besseren Benetzung beim zweiten Epitaxieprozeß und zur Reinigung der seitlichen Begrenzungsflächen des Streifens ist bereits ein Remelt-bzw. Auflösungsverfahren bekannt, bei dem die seitlichen Begrenzungsflächen des Streifens durch Abtragschmelzen in Form untersättigter Schmelzen angelöst werden. Das Auflösen oder Remelting erfolgt aber nur sehr kurz, beispielsweise 2 Sekunden mit In,P-Schmelze oder mit einer In,As-Schmelze, um ein zu starkes Anlösen der laseraktiven Schicht des Streifenlasers zu verhindern. Die seitlichen Begrenzungsflächen des Streifens bleiben im wesentlichen eben. Nach dem kurzen Remelting wird die Abtragschmelze abgeschoben und danach eine Wachstumsschmelze zum Aufwachsen einer epitaktischen Schicht aufgeschoben, welche die seitlichen Begrenzungsflächen des Streifens überwächst. Zwischen dem Abschieben der Abtrag schmelze und dem Aufschieben der Wachstumsschmelze sind diese seitlichen Begrenzungsflächen freigelegt und Chemikalien und/oder einwirkenden Atmosphären, beispielsweise der Atmosphäre des Prozeßreaktors ausgesetzt. Dadurch wird die Qualität der entstehenden seitlichen Grenzfläche zwischen den Streifen und der nachträglich aufgewachsenen Epitaxieschicht vermindert. Diese verminderte Qualität bedingt nicht perfekte seitliche Heteroübergänge, die Ursache für Alterungsmechanismen sind, die Halbleiterlaser mit BH-Schichtstruktur, bei denen die laseraktive Zone eine vergrabene Zone ist, zeigen.

Aufgabe der Erfindung ist es, ein Verfahren der eingangs genannten Art dahingehend zu verbessern, daß die seitlichen Begrenzungsflächen zu keiner Zeit einer schädlichen Atmosphäre und/oder Chemikalien ausgesetzt sind.

Diese Aufgabe wird durch die im kennzeichnenden Teil des Patentanspruchs 1 angegebenen Merkmale gelöst.

Mit der erfindungsgemäßen Lösung können Grenzflächen hoher Perfektion zwischen dem Streifen und der nachträglich aufgewachsenen Epitaxieschicht und damit auch seitliche Heteroübergänge hoher Perfektion erhalten werden.

Eine bevorzugte und vorteilhafte Ausgestaltung des erfindungsgemäßen Verfahrens ist im Anspruch 2 angegeben. Sie macht von der Tatsache Gebrauch, daß bei der Flüssigphasenepitaxie von Schichtstrukturen aus Materialien verschiedener Zusammensetzung, beispielsweise der Doppelheterostruktur eines Halbleiterlasers, nicht nur beim Abkühlen des Systems im allgemeinen die Wachstumsraten für verschiedene Halbleiterzusammensetzungen verschieden ist, sondern daß in Gegenwart untersättigter Schmelzen bzw. bei Temperaturerhöhung auch die Auflöse-bzw. Remelt-Geschwindigkeit im allgemeinen für verschiedene Zusammensetzungen der Halbleiterschichten verschieden ist. Dabei wird der Auflöse-bzw. Remelteffekt so ausgenutzt, daß bei seitlichem Angriff eines erhabenen Streifens mit Hetero-Schichtstruktur durch den Angriff von Abtragschmelzen eine bestimmte Schicht auf beiden Seiten stärker abgetragen wird als die angrenzenden Schichten.

Das Verfahren nach Anspruch 2 kann so durchgeführt werden, wie es im Anspruch 3 angegeben ist. Besonders vorteilhaft ist es jedoch, dieses Verfahren nach Anspruch 2 so durchzuführen, wie es im Anspruch 4 angegeben ist.

Eine bevorzugte Ausgestaltung des erfindungsgemäßen Verfahrens geht aus Anspruch 5 hervor.

Die Verfahrensvarianten nach Anspruch 6 oder 7 sind zur Herstellung von quaternären Lasern mit einer Doppelheterostruktur geeignet, bei der die laseraktive Schicht aus InGaAsP und die angrenzenden Schichten aus InP bestehen. Dabei wird die laseraktive Schicht auf beiden Seiten stärker abgetragen als die angrenzenden Schichten. Das Verfahren nach Anspruch 7, bei dem nach der Temperaturerhöhung, vorzugsweise in Form eines Temperatursprunges der Auflöse-bzw. Remeltvorgang bis zur Sättigung abläuft, wird zweckmäßigerweise gemäß Anspruch 8 durchgeführt, da durch das anschließende Absenken der Temperatur dieser Remeltvorgang in einen Wachstumsprozeß umschlägt.

Auf diese Weise ist ein schonendes Verfahren zur Erzeugung der InGaAsP-InP-Grenzflächen gegeben, bei der diese Flächen mit Sicherheit nicht äußeren Einflüssen ausgesetzt sind und im allgemeinen eine hohe Perfektion aufweisen.

Die Erfindung wird im Vergleich zu einem bekannten Verfahren in der folgenden Beschreibung anhand der Figuren näher erläutert. Von den Figuren zeigen

Figur 1 einen Querschnitt durch eine Epitaxiescheibe mit Doppelheteroschichtstruktur, aus der ein erhabener Streifen entsprechend der Breite eines Streifenlasers geätzt ist,

Figur 1b die Scheibe nach Figur 1, wobei die seitlichen Begrenzungsflächen des erhabenenen Streifens mit einer Epitaxieschicht aus InP zugewachsen sind,

Figur 2a einen Querschnitt durch eine Epitaxiescheibe mit Doppelhetero-Schichtstruktur, aus der ein erhabener Streifen bis zur bestimmten Schicht herausgeätzt ist, wobei die Breite des Streifens größer als die Breite des späteren Streifenlasers gewählt ist,

Figur 2b die Epitaxiescheibe in der Darstellung nach Figur 2a nach dem Remeltvorgang und

Figur 2c die Epitaxiescheibe in der Darstellung nach Figur 2b nach dem Zuwachsen der seitlichen Begrenzungsflächen durch eine Epitaxieschicht aus InP.

Die Figuren zeigen ausschließlich schematische Darstellungen.

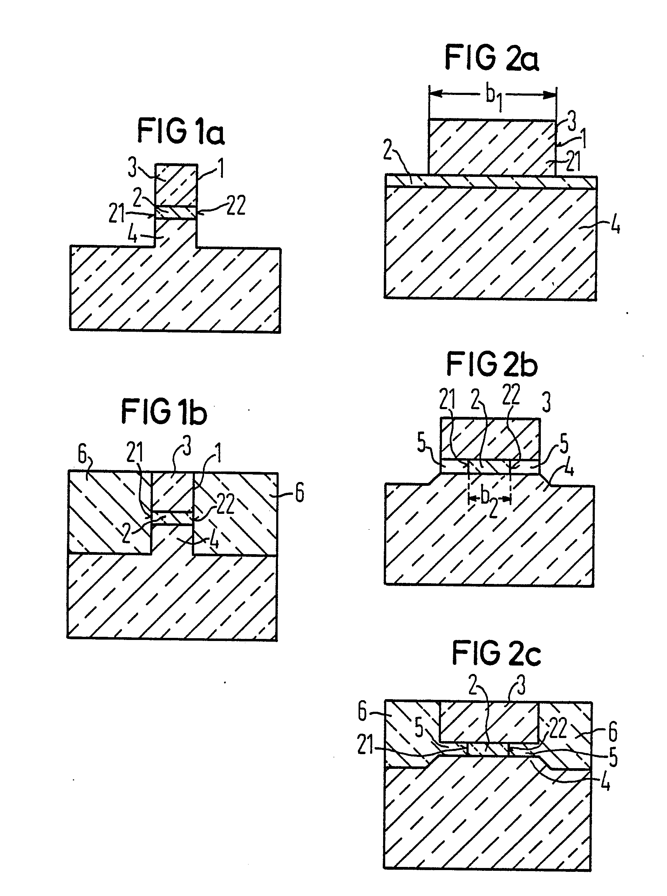

Bei den Figuren 1a und 1b ist angenommen, daß vor dem Aufwachsen der Epitaxieschicht 6 aus InP zur besseren Benetzung und zur Reinigung der seitlichen Begrenzungsflächen des Streifens 1, insbesondere der seitlichen Begrenzungsflächen 21, 22 der die bestimmte Schicht 2 bildenden InGaAsP-Schicht der Doppelhetero-Schichtstruktur bereits ein Remeltvorgang durch Verwendung untersättigter Schmelzen vorgenommen worden ist, der jedoch nur sehr kurz, beispielsweise 2 Sekunden, mit einer In,P-Schmelze oder mit einer In,As-Schmelze erfolgt, um ein zu starkes Anlösen der Schicht 2 zu verhindern. Die Seitenflächen des Streifens 1 sind deshalb im wesentlichen eben. Zwischen dem Abschieben der Abtragschmelze und dem Aufschieben der nachfolgenden Wachstumsschmelze sind die seitlichen Begrenzungsflächen des Streifens 1 wieder freigelegt und der Atmosphäre des Prozeßreaktors ausgesetzt.

Dies wird beim erfindungsgemäßen Verfahren vermieden. Beispielsweise wird zuerst ein erhabener Streifen in die Doppel hetero-Schichtstruktur bis zur bestimmten Schicht 2 geätzt (Figur 2a). Die Breite $b_1$ des Streifens 1 ist größer als die Breite $b_2$ des späteren Streifenlasers gewählt. Zum Erzeugen der seitlichen Begrenzungsflächen 21, 22 der bestimmten Schicht 2 wird eine Abtragschmelze aufgeschoben, deren Einwirkungszeit so groß gewählt wird, daß ein Randbereich 5 der Schicht 2, in dem das Material dieser Schicht aufgelöst ist, zwischen unaufgelösten Abschnitten der von oben und von unten her an die Schicht 2 angrenzenden festen Schichten 3 und 4 der Doppelhetero-Schichtstruktur vorhanden ist.

Durch Einstellung des Sättigungsgrades bzw. der Temperaturerhöhung läßt sich eine definitive Breite der Randbereiche 5 zu beiden Seiten der Schicht 2 erreichen, in denen das Material dieser Schicht 2 gelöst ist. Beim Abschieben der Schmelzen nach beendetem Remelting wird Schmelze in den Randbereichen 5 verbleiben, so daß die an die Randbereiche 5 angrenzenden seitlichen Begrenzungsflächen 21 und 22 der unaufgelösten Schicht 2 aus InGaAsP nicht freigelegt werden. Mit einer nachfolgenden übersättigten In,P-Schmelze kann dann die an die seitlichen Begrenzungsflächen 21 und 22 der Schicht 2 angrenzende Epitaxieschicht 6 erzeugt werden (Figur 2c).

Vorteilhafter ist es, auf das Abschieben der aufgebrachten Abtragschmelze zu verzichten, so daß diese an dem erhabenen Streifen 1 belassen wird, und diese Abtragschmelze, die sich beim Remeltvorgang sättigt, direkt als Wachstumsschmelze zur Erzeugung der an die seitlichen Begrenzungsflächen 21 und 22 der Schicht 2 angrenzenden Epitaxieschicht 6 zu verwenden.

Für den Remeltvorgang, insbesondere zum Erzeugen der seitlichen Begrenzungsflächen 21 und 22 der Schicht 2 im Ausführungsbeispiel, bei dem der erhabene Streifen 1 nur bis zur bestimmten Schicht herausgeätzt wird (Fig. 2b) sind folgende Möglichkeiten geeignet:

i) eine untersättigte In,P-Schmelze als Abtragschmelze bei absinkender Temperatur,

ii) eine untersättigte In,P-Schmelze als Abtragschmelze bei konstanter Temperatur, und

iii) eine in etwa gesättigte In,P-Schmelte als Abtragschmelze mit anschließender Temperaturerhöhung.

Für das Verfahren, bei dem auf das Abschieben der Abtragschmelze verzichtet wird, ist insbesondere die Möglichkeit iii) geeignet, bei der nach dem Temperatursprung der Schmelzprozeß bis zur Sättigung abläuft und durch anschließendes Absenken der Temperatur in einen Wachstumsprozeß umschlägt.

Ein hier beschriebenes Verfahren eignet sich nicht nur zur Herstellung von Streifenlasern sondern generell zur Herstellung von Streifenwellenleitern mit Hetero-Schichtstruktur, bei denen der wellenleitende Bereich seitliche Begrenzungsflächen guter Qualität aufweist.

Bekannte Literatur: Elecronics Letters 16 (1980) S. 349-350;
J. Appl. Phys. 50 (1979) S. 7934-7938

**Ansprüche**

1. Verfahren zur Erzeugung eines Streifenwellenleiters, wobei aus einer epitaktischen Hetero-Schichtstruktur in erhabener Streifen (1) herausgeätzt und dieser Streifen (1) mittels einer Abtragschmelze seitlich angelöst wird, **dadurch gekennzeichnet,** daß eine seitliche Begrenzungsfläche (21, 22) einer bestimmten, als wellenleitender Bereich des Streifenwellenleiters fungierenden Schicht (2) der Hetero-Schichtstruktur von der Abtragschmelze oder/und einem von dieser Schmelze gelösten Teil (5) dieser bestimmten Schicht abgedeckt belassen wird, und daß diese abdeckende Abtragschmelze oder/und der abdeckende gelöste Teil (5) als eine Wachstumsschmelze zur Erzeugung einer an die seitliche Begrenzungsfläche (21, 22) der bestimmten Schicht (2) angrenzenden Epitaxieschicht (6) verwendet wird.

2. Verfahren nach Anspruch 1, **dadurch gekennzeichnet,** daß eine Abtragschmelze gewählt wird, bei der die bestimmte Schicht (2) von der Seite her schneller gelöst wird als Schichten (3, 4) der Hetero-Schichtstruktur, die von oben und unten an diese bestimmte Schicht (2) angrenzen, und daß die Einwirkungszeit der Abtragschmelze so groß gewählt wird, daß das Material der bestimmten Schicht (2) in einem zwischen unaufgelösten Abschnitten (30, 40) der angrenzenden Schichten (3, 4) der Hetero-Schichtstruktur befindlichen Randbereich (5) der bestimmten Schicht (2) gelöst ist.

3. Verfahren nach Anspruch 2, **dadurch gekennzeichnet,** daß die Abtragschmelze bis auf den gelösten Randbereich (5) der bestimmten Schicht (2) entfernt und danach eine Wachstumsschmelze aufgebracht wird, aus der zusammen mit dem gelösten Randbereich (5) die an die seitliche Begrenzungsfläche (21, 22) der bestimmten Schicht (2) angrenzende Epitaxieschicht (6) erzeugt wird.

4. Verfahren nach Anspruch 2, **dadurch gekennzeichnet,** daß die aufgebrachte Abtragschmelze am erhabenen Streifen (1) belassen und zugleich als Wachstumsschmelze zur Erzeugung der an die seitliche Begrenzungsfläche (21, 22) der bestimmten Schicht (2) angrenzenden Epitaxieschicht (6) verwendet wird.

5. Verfahren nach einem der Ansprüche 2 bis 4, **dadurch gekennzeichnet,** daß der erhabene Streifen (1) nur bis zur bestimmten Schicht (2) aus der Hetero-Schichtstruktur herausgeätzt wird.

6. Verfahren nach einem der vorhergehenden Ansprüche, **dadurch gekennzeichnet,** daß die bestimmte Schicht (2) aus InGaAsP und die angrenzenden Schichten (3, 4) aus InP bestehen, daß als Abtragschmelze eine untersättigte InP-Schmelze verwendet wird und daß während des Lösungsvorganges die Temperatur entweder abgesenkt oder konstant gehalten wird.

7. Verfahren nach einem der Ansprüche 1 bis 5, insbesondere nach Anspruch 4, **dadurch gekennzeichnet,** daß die bestimmte Schicht (2) aus InGaAsP und die beidseitig angrenzenden Schichten (3, 4) aus InP bestehen, daß als Abtragschmelze eine in etwa gesättigte InP-Schmelze verwendet wird, und daß eine Temperaturerhöhung vorgenommen wird.

8. Verfahren nach Anspruch 4 und 7, **dadurch gekennzeichnet,** daß nach Ablauf des Lösungsvorganges eine Temperaturabsenkung vorgenommen wird.

FIG 1a

FIG 1b

FIG 2a

FIG 2b

FIG 2c